(19) Europäisches Patentamt

European Patent Office

Office européen des brevets

(11) **EP 0 981 502 B1**

(12) **FASCICULE DE BREVET EUROPEEN**

(45) Date de publication et mention de la délivrance du brevet:
**10.09.2003 Bulletin 2003/37**

(21) Numéro de dépôt: **98925700.1**

(22) Date de dépôt: **12.05.1998**

(51) Int Cl.$^7$: **C03C 25/22**, C23C 16/34

(86) Numéro de dépôt international:
**PCT/FR98/00949**

(87) Numéro de publication internationale:
**WO 98/051632 (19.11.1998 Gazette 1998/46)**

(54) **PROCEDE DE DEPOT D'UNE COUCHE DE REVETEMENT SUR UNE FIBRE OPTIQUE AU COURS DE SON FIBRAGE ET DISPOSITIF DE MISE EN OEUVRE**

VERFAHREN ZUR BEKLEIDUNG EINER OPTISCHEN FASER MIT EINER SCHICHT WÄHREND DES ZIEHENS UND ANORDNUNG ZUR DURCHFÜHRUNG DIESES VERFAHRENS

METHOD FOR DEPOSITING A COATING LAYER ON AN OPTICAL FIBRE WHILE IT IS BEING DRAWN AND DEVICE FOR ITS IMPLEMENTATION

(84) Etats contractants désignés:
**DE FR GB IT**

(30) Priorité: **14.05.1997 FR 9705893**

(43) Date de publication de la demande:
**01.03.2000 Bulletin 2000/09**

(73) Titulaire: **FRANCE TELECOM**
**75015 Paris (FR)**

(72) Inventeurs:
• **RUELLO, Yves**
 **F-22300 Lannion (FR)**
• **CADIER, Benoit**
 **F-22560 Trebeurden (FR)**

(74) Mandataire: **Bentz, Jean-Paul et al**
**Cabinet Ballot**
**4 rue du Général Hoche**
**BP 855**
**56100 Lorient (FR)**

(56) Documents cités:
EP-A- 0 222 960    WO-A-96/06054
US-A- 4 118 211

• DATABASE WPI Section Ch, Week 8916 Derwent Publications Ltd., London, GB; Class E36, AN 89-117839 XP002055678 & JP 01 062 471 A (FUJITSU LTD) , 8 mars 1989
• PATENT ABSTRACTS OF JAPAN vol. 010, no. 206 (P-478), 18 juillet 1986 & JP 61 046915 A (SUMITOMO ELECTRIC IND LTD), 7 mars 1986
• DATABASE WPI Section Ch, Week 8138 Derwent Publications Ltd., London, GB; Class A89, AN 81-68904D XP002055679 & JP 56 097 303 A (FUJIKURA CABLE WORKS LTD) , 6 août 1981

## Description

La présente invention se rapporte à un procédé de dépôt d'une couche de revêtement sur une fibre optique au cours de son fibrage. Cette couche de revêtement est destinée à améliorer l'étanchéité et la durée de vie de la fibre optique.

Aujourd'hui, les fibres optiques sont largement utilisées sur les réseaux de transmission longue distance. Elles sont également vouées à assurer le transport d'informations jusque chez un usager résidentiel. Ces fibres , réalisées dans de la silice, sont cependant sensibles à l'humidité ambiante qui affaiblit grandement leur résistance à la fatigue et par conséquent diminue leur durée de vie.

Un problème consiste donc à trouver une solution pour protéger, à moindre coût, les fibres optiques contre l'humidité ambiante sans dégrader leur résistance mécanique. Pour cela, plusieurs types de revêtements dits "hermétiques", présentant une très faible perméabilité à la vapeur d'eau, ont déjà été étudiés et développés.

Ces revêtements hermétiques permettent d'augmenter la résistance des fibres à la fatigue et par conséquent leur durée de vie.

La relation suivante exprime la durée de vie d'une fibre en fonction de la contrainte critique $\sigma c$, de la contrainte appliquée $\sigma a$, et d'un facteur n traduisant la perméabilité de la fibre :

$$tf = B^* \ \sigma c^{n-2}/\sigma a^{n};$$

et B est une constante.

Après avoir mesuré la durée de vie tf, c'est-à-dire le temps à la rupture, en fonction de différentes contraintes appliquées, la valeur de n peut être déduite en traçant la courbe ln tf = f(ln $\sigma a$).

Il apparaît que plus la perméabilité de la fibre à la vapeur d'eau est faible, plus le facteur n est élevé et donc plus la durée de vie tf est allongée.

Les différents revêtements hermétiques ayant été étudiés jusqu'à présent, sont des matériaux de type céramique, métallique, carbone, et polymères hydrophobes.

Les céramiques sont par exemple de type carbure de silicium, carbure de titane ou nitrure de silicium. Leur dépôt sur des fibres optiques est réalisé selon la technique bien connue de dépôt chimique en phase vapeur, encore dénommée "Chemical Vapor Deposition" (CVD) en terminologie anglo-saxonne. Dans ce cas, la vitesse de dépôt associée à ce procédé est de l'ordre de 60 nm/min, ce qui est beaucoup trop faible pour être compatible avec un procédé dynamique de fibrage dans lequel la vitesse de défilement d'une fibre optique est en général supérieure à 20 m/min. De plus, les dépôts de ce type de revêtement sont nécessairement effectués sur des substrats chauffés à une température supérieure ou égale à 900°C.

Les revêtements métalliques, tels que l'aluminium, le zinc ou le fer blanc par exemple, sont obtenus par un procédé dit de "freezing" consistant à imprégner une fibre de métal fondu. Ce type de procédé ne peut en aucun cas être utilisé au cours d'une opération de fibrage. En effet, la vitesse de dépôt est très limitée par le refroidissement du métal fondu et n'est donc pas compatible avec la vitesse de fibrage. Les fibres recouvertes de tels revêtements ne sont utilisées que pour des applications spécifiques comme la fabrication de capteurs ou de fibres pour composants par exemple, ou pour leur résistance aux hautes températures dans le cas de métaux tels que l'aluminium, le cuivre ou l'or par exemple. De plus, ces revêtements métalliques sont nécessairement déposés sur des substrats chauffés à des températures supérieures ou égales à 900°C.

Des dépôts de carbone ont également été envisagés. Ces dépôts concernent aussi bien le carbone de type "diamant" que le carbone de type "graphite". Ils sont réalisés selon la technique classique de dépôt chimique en phase vapeur (CVD), à la pression atmosphérique, sur des fibres placées dans un réacteur. Les fibres obtenues présentent en général une bonne résistance à la fatigue, avec un facteur n de l'ordre de 100, mais leur résistance mécanique se trouve dégradée. De plus, les réactifs utilisés, de type hydrocarbures, sont présents en grandes quantités et viennent encrasser les parois du réacteur. Du fait de cette pollution, des dépôts de bonne qualité ne peuvent se faire que sur des longueurs très limitées de fibres et des procédures de recyclage doivent être fréquemment effectuées. Par conséquent, le coût des fibres est considérablement accru.

Le carbone de type "diamant" se dépose sur une fibre chauffée à partir de 200°C. Mais, à cette température, il se dépose simultanément sur les parois du réacteur. Pour éviter un tel encrassement, il faudrait refroidir les parois du réacteur de manière significative par rapport à la fibre. Or un tel refroidissement est très difficile à réaliser à des températures inférieures à 200°C.

Enfin, des revêtements de polymères hydrophobes ont été étudiés. La mise en oeuvre des dépôts est identique à celle d'un dépôt classique. Cependant, ce type de revêtement voit son étanchéité diminuer constamment après exposition à l'humidité et il perd ses propriétés hydrophobes après quelques années.

Le document WO-A-96/06054 décrit un procédé de dépôt de bore sur une fibre optique.

La présente invention permet de pallier les inconvénients précités puisqu'elle propose un procédé peu coûteux, permettant de déposer un revêtement hermétique sur une fibre optique avec une très grande vitesse, compatible avec le procédé de fibrage, sans dégrader les propriétés mécaniques de la fibre.

Elle se rapporte plus particulièrement à un procédé de dépôt d'une couche de revêtement sur une fibre optique au cours de son fibrage, ladite couche de revêtement étant destinée à améliorer l'étanchéité et la durée de vie de ladite fibre optique, caractérisé en ce qu'il consiste à décomposer un mélange gazeux d'halogénure de bore et d'hydrogène et/ou d'halogénure de bore et d'ammoniac, au moyen d'un apport d'énergie assisté par plasma micro-ondes, et en ce que l'on opère en présence d'un gaz vecteur pour d'une part entraîner ledit mélange gazeux vers un milieu réactionnel et d'autre part activer le plasma.

Le bore avoisine le carbone dans la classification périodique des éléments et possède donc des propriétés similaires à celles du carbone. Ainsi, il présente une chimie à fort caractère covalent. De plus, sa structure électronique explique son faible rayon atomique, sa forte densité et sa très grande dureté. Il possède par ailleurs un faible coefficient de dilatation et une température de ramollissement élevée. Le nitrure de bore, quant à lui, est également très dur et est en général utilisé pour améliorer la résistance à d'abrasion et à l'usure de certains objets.

L'obtention de bore par réduction d'halogénures de bore, tels que des chlorures ou des bromures, sous hydrogène est bien connue sous le nom de réaction de Van Arkel. De la même manière, l'obtention de nitrure de bore se fait par réduction d'halogénure de bore en présence d'ammoniac. En général, l'énergie nécessaire à la réaction chimique est apportée soit par chauffage au cours d'un dépôt en phase vapeur (CVD), soit par chauffage assisté par plasma au cours d'un dépôt en phase vapeur encore dénommé "Plasma Assisted Chemical Vapor Déposition" (PACVD) en terminologie anglo-saxonne.

Il apparaît d'autre part que le bromure de bore est un réactif intéressant car il permet de réaliser des dépôts sur des substrats chauffés à des températures à partir de 400°C qui sont suffisamment basses pour éviter un encrassement des parois du réacteur.

Le gaz vecteur quant à lui, permet d'entraîner le mélange gazeux à l'intérieur d'une chambre réactionnelle et d'activer le plasma. La présence de ce gaz vecteur permet par conséquent d'augmenter la vitesse de réaction de décomposition de l'halogénure de bore, et donc d'augmenter la vitesse de dépôt de bore et/ou de nitrure de bore sur la fibre.

Grâce au procédé selon l'invention, la vitesse de dépôt est élevée, de l'ordre de 300 à 500 μm/h, et compatible avec la vitesse de fibrage d'une fibre optique. La couche de revêtement obtenue permet d'augmenter la résistance de la fibre à la fatigue, le facteur n étant supérieur ou égal à 100, sans dégrader sa résistance mécanique. Le procédé selon l'invention est par ailleurs peu coûteux.

Un autre objet de l'invention concerne un dispositif de mise en oeuvre de ce procédé. Ce dispositif est caractérisé en ce qu'il comprend :

- une chambre réactionnelle tubulaire comprenant, à chacune de ses extrémités respectivement un sas d'entrée et un sas de sortie permettant le passage en continu de la fibre optique à l'intérieur de ladite chambre,
- un système de refroidissement permettant de maintenir la paroi de la chambre réactionnelle à une température constante inférieure à 100°C,
- un groupe de pompage relié d'une part à la chambre réactionnelle pour piéger les gaz résiduels et maintenir une pression constante, et d'autre part aux sas d'entrée et de sortie pour maintenir une pression proche ou identique à celle qui règne à l'intérieur de la chambre réactionnelle,
- une centrale de gaz reliée au sas d'entrée et/ou à la chambre réactionnelle, et
- des moyens de production d'un chauffage assisté par plasma micro-onde.

D'autres particularités et avantages de l'invention apparaîtront à la lecture de la description détaillée faite à titre d'exemple illustratif et non limitatif en référence aux figures annexées qui représentent :

- la figure 1, un schéma d'une tour de fibrage classique dans laquelle un dispositif de mise en oeuvre du procédé selon l'invention a été inséré,
- la figure 2, un schéma d'un dispositif selon l'invention,
- la figure 3, un schéma des sas d'entrée et de sortie situés de part et d'autre de la chambre réactionnelle du dispositif de la figure 2.

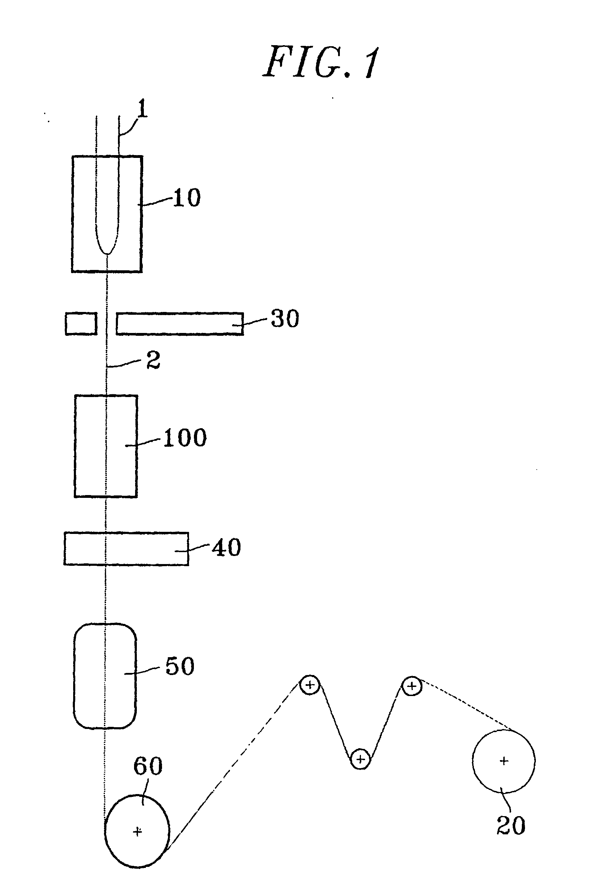

L'opération de fibrage consiste à transformer une préforme en fibre. Sur la figure 1, la préforme est référencée 1 et la fibre est référencée 2. La préforme 1 est chauffée dans un four à haute fréquence 10, à une température telle qu'elle puisse être étirée. En général, cette température est supérieure ou égale à 2400°C. La silice en fusion est alors étirée de manière à former une fibre 2.

La fibre 2 issue du four de fibrage doit avoir des dimensions constantes et bien définies. Ces dimensions sont notamment fonction de la température de fibrage et de la traction appliquée à la fibre. Un appareil 30 permet donc de mesurer le diamètre de la fibre 2. Cette mesure de diamètre sert par ailleurs à l'asservissement de la vitesse d'un tambour 20 sur lequel vient s'enrouler la fibre 2.

Cependant, une telle fibre 2 est fragile et de légers dommages créés à sa surface peuvent nuire considérablement à la résistance mécanique de celle-ci. C'est pourquoi, il est important que la fibre 2 soit recouverte d'un revêtement protecteur résistant à l'abrasion qui peut être causée notamment par le tambour 20. Ce revêtement protecteur est déposé sur la fibre, à la sortie du four de fibrage, en faisant passer la fibre 2 dans un réservoir 40 contenant un plastique à l'état liquide. Le plastique recouvrant la fibre est ensuite solidifié, soit sous l'action de la chaleur, dans un four de polymérisation 50, soit sous l'action des ultra-volets. Le plastique peut être une résine siliconée, du fluorure de polyvinylidène, du polytétrafluoroéthylène, du polyimide ou du polyacrylate de méthane. Le revêtement et la fibre doivent être rigoureusement concentriques. La fibre 2 est ensuite transférée sur un cabestan 60, lequel permet de réguler la vitesse de fibrage, avant d'être enroulée sur le tambour 20.

Le revêtement plastique utilisé pour protéger la fibre 2 contre l'abrasion n'est cependant pas imperméable à la vapeur d'eau : le facteur n est faible, de l'ordre de 20 à 30. Par conséquent, pour pouvoir améliorer l'étanchéité de la fibre à la vapeur d'eau, un deuxième revêtement doit être déposé sur la fibre. De préférence, ce revêtement hermétique est déposé directement sur la fibre en sortie du four de fibrage et avant le dépôt du revêtement résistant à l'abrasion.

Le dispositif permettant de mettre en oeuvre le dépôt de revêtement hermétique est donc placé à la sortie du four de fibrage 10 et avant le réservoir 40 de plastique liquide. Ce dispositif est référencé 100 sur la figure 1.

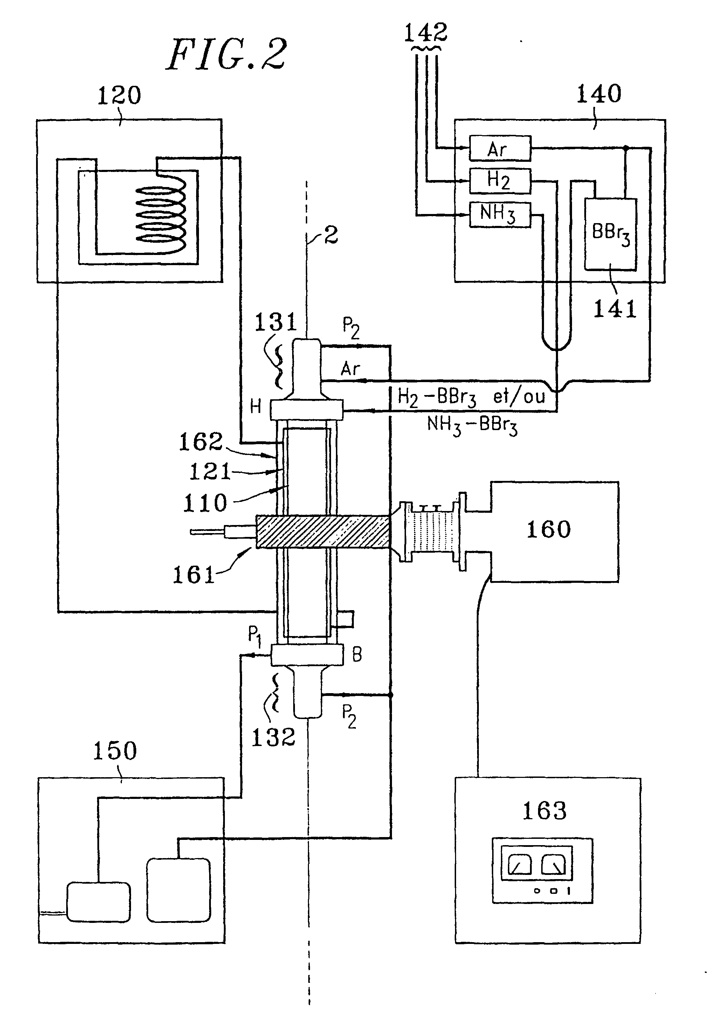

Le procédé selon l'invention et le dispositif de mise en oeuvre seront mieux compris en regard de la figure 2 qui schématise un mode de réalisation du dispositif selon l'invention.

Le procédé selon l'invention consiste à déposer un revêtement contenant du bore et/ou du nitrure de bore sur une fibre défilant à grande vitesse. La vitesse de fibrage est en général supérieure à 20 m/min et peut atteindre des valeurs de l'ordre de 500 m/min.

Dans la suite de la description, la fibre 2, encore dénommée substrat, est en silice et présente un diamètre de 125 $\mu$m. Bien sûr, ceci n'est qu'un exemple et dans une variante de réalisation le substrat peut aussi se présenter sous la forme d'un tube ou tout autre profil en silice de quelques mm$^2$ de section.

Un mode préféré de réalisation du procédé de dépôt selon l'invention consiste à décomposer un mélange gazeux d'halogénure de bore et d'hydrogène et/ou d'halogénure de bore et d'ammoniac, au moyen d'un apport d'énergie de réaction assisté par plasma micro-onde. L'énergie de réaction est par exemple apportée sous forme thermique. De préférence l'halogénure de bore est du tribromure de bore. Ce réactif est en effet intéressant car il permet le dépôt de bore ou de nitrure de bore sur une fibre chauffée à une température relativement basse, supérieure ou égale à 400°C.

D'autre part, un gaz vecteur inerte vis-à-vis du milieu réactionnel est avantageusement utilisé pour à la fois entraîner le mélange gazeux vers le milieu réactionnel et activer le plasma. Grâce à la présence de ce gaz vecteur, la vitesse de réaction de décomposition de l'halogénure de bore augmente considérablement. Par conséquent, la vitesse de dépôt de bore et/ou de nitrure de bore est beaucoup plus élevée qu'en l'absence de ce gaz vecteur. Ce gaz peut par exemple être de l'azote ou de l'argon. L'argon est de préférence utilisé car il permet une meilleure activation du plasma et donc un meilleur rendement de la réaction de décomposition du tribromure de bore.

Les réactions de décomposition du tribromure de bore en présence d'hydrogène ou d'ammoniac s'écrivent de la manière suivante :

$$2\ BBr_3 + 3H_2 \rightarrow 2B + 6\ HBr : \text{dépôt de bore}$$

$$BBr_3 + NH_3 \rightarrow BN + 3\ HBr : \text{dépôt de nitrure de bore.}$$

Dans les deux cas, l'hydrogène et l'ammoniac sont de préférence en excès par rapport à l'halogénure pour s'assurer d'une décomposition totale du tribromure de bore.

Le dispositif selon l'invention placé sur la ligne de fibrage, en sortie du four de fibrage, comprend : une chambre réactionnelle 110, un système de refroidissement 120, un groupe de pompage 150, une centrale de gaz 140 et des moyens 160,161,162,163 destinés à la production du chauffage assisté par plasma micro-ondes.

Le bore et/ou le nitrure de bore doivent se déposer à très grande vitesse sur la fibre défilant à travers le milieu réactionnel. Du fait de la configuration filaire du substrat et pour maintenir une qualité de dépôt compatible avec de grandes vitesses de fibrage, il a fallu chercher à étendre la zone plasma suivant l'axe de déplacement de la fibre 2.

Pour cela, la chambre réactionnelle 110 se présente avantageusement sous une forme tubulaire. Elle est de préférence en quartz. Elle possède un diamètre intérieur de l'ordre de 20 mm et une longueur de l'ordre de un mètre par exemple. Bien sûr, les dimensions de la chambre réactionnelle ne sont pas limitées à ces valeurs, elles peuvent être plus au moins élevées. La chambre réactionnelle 110 est en outre disposée symétriquement de part et d'autre d'un coupleur destiné à entretenir le plasma.

Un système de refroidissement 120 est en outre avantageusement prévu pour maintenir la paroi de la chambre réactionnelle à une température constante inférieure à 100°C. Pour cela, la chambre réactionnelle 110 comporte une double paroi 121 à l'intérieur de laquelle une huile diélectrique, à base de silicone par exemple, est injectée à partir du système de refroidissement 120. Cette huile présente une température constante de l'ordre de 5°C et circule en circuit fermé. Elle est injectée dans la double paroi 121, à l'extrémité inférieure B de la chambre réactionnelle et ressort à l'extrémité supérieure H de la chambre réactionnelle.

La double paroi 121 est avantageusement constituée par un deuxième tube en quartz dont le diamètre intérieur est par exemple compris entre 29 et 35 mm.

Grâce à ce système de refroidissement, il est possible de maintenir la paroi de la chambre réactionnelle à une température voisine de 100°C ou inférieure, ce qui permet d'éviter tout risque d'encrassement par dépôt des réactifs sur cette paroi.

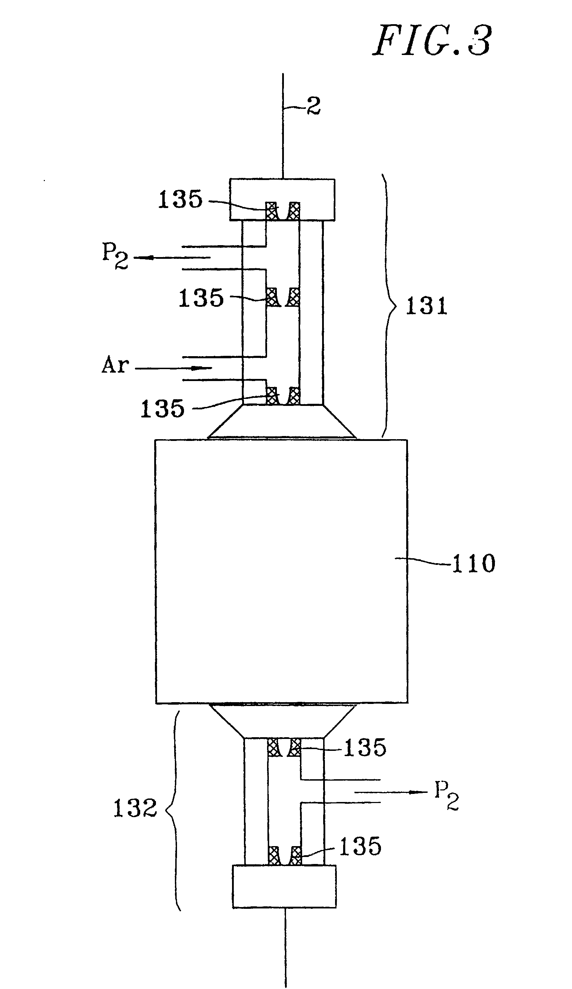

D'autre part, la chambre réactionnelle 110 comprend, à chacune de ses extrémités, respectivement un sas d'entrée 131 et un sas de sortie 132. Le sas d'entrée 131 est situé à l'extrémité haute H de la chambre réactionnelle et le sas de sortie 132 est situé à l'extrémité basse B de la chambre réactionnelle. Ces deux sas sont conçus de manière à permettre le passage en continu de la fibre optique 2 à l'intérieur de la chambre réactionnelle 110. Ils sont décrit de manière plus détaillée dans la description faite en référence à la figure 3.

Une centrale de gaz 140 est par ailleurs reliée au sas d'entrée 131 et/ou à la chambre réactionnelle 110 pour permettre l'injection d'une part du gaz vecteur, et d'autre part du mélange gazeux de tribromure de bore et d'hydrogène et/ou de tribromure de bore et d'ammoniac.

Les gaz sont de préférence stockés dans des bouteilles placées dans une armoire à l'extérieur des bâtiments. Ils sont véhiculés vers la centrale 140 à travers des conduites 142.

La centrale de gaz est de préférence munie d'une régulation thermostatique de manière à éviter les éventuels phénomènes de condensation et à maintenir les gaz à une température constante, de l'ordre de 40°C. De plus, le tribromure de bore est avantageusement contenu dans un bulleur 141 dont la température est également maintenue à environ 40°C.

La centrale 140 permet en outre de fabriquer le mélange gazeux de tribromure de bore et d'hydrogène et/ou de tribromure de bore et d'ammoniac. Pour cela, un ensemble de débitmètres, référencés $H_2$ et $NH_3$ sur la figure 2, permet de contrôler le débit d'hydrogène et/ou d'ammoniac passant dans le bulleur 141 pour entraîner le tribromure de bore. De même, un débitmètre référencé Ar est réservé pour le contrôle du débit du gaz vecteur. La quantité de tribromure de bore entraînée dépend non seulement de la température du bulleur 141, mais aussi du débit des gaz hydrogène, ammoniac et argon utilisés.

De préférence l'hydrogène et/ou l'ammoniac est en excès par rapport au tribromure de bore de manière à s'assurer de l'entière décomposition de l'halogénure de bore. De plus, du fait de la présence du gaz vecteur, qui permet d'entraîner le mélange gazeux et d'activer le plasma, il est possible d'utiliser de faibles quantités de réactifs. Ainsi, le rapport volumique entre l'hydrogène et le tribromure de bore ($H_2/BBr_3$), et/ou le rapport volumique entre l'ammoniac et le tribromure de bore ($NH_3/BBr_3$), est inférieur à 50. De préférence, il est compris entre 15 et 40.

Le débit d'hydrogène et/ou d'ammoniac est de préférence compris entre 200 et 1000 cm$^3$/min, et le gaz vecteur argon s'écoule avec un débit compris entre 10 et 100 cm$^3$/min.

D'autre part, le gaz vecteur circulant dans le milieu réactionnel est situé à proximité de la fibre optique de sorte qu'il permet d'augmenter la réactivité de la surface de la fibre. De ce fait, le dépôt de bore et/ou de nitrure de bore sur la surface de la fibre est facilité et présente de meilleures qualités.

Un groupe de pompage 150 est en outre relié aux sas d'entrée 131 et de sortie 132 et à la chambre réactionnelle 110. Ce groupe de pompage permet d'effectuer deux types de pompage.

Un premier pompage P1 est réalisé à l'extrémité inférieure B de la chambre réactionnelle 110 afin de maintenir une pression constante dans la chambre 110 et de piéger les gaz résiduels éventuels. Ce premier pompage peut se faire au moyen d'une pompe sèche par exemple. La faible quantité de réactifs utilisés associée à l'aspiration continue P1 permet d'éliminer les problèmes liés à la pollution et au recyclage qui en découle.

Un pompage secondaire P2, ou différentiel, est d'autre part effectué dans les sas d'entrée 131 et de sortie 132. Ce pompage différentiel P2 permet de maintenir, dans les deux sas d'entrée et de sortie, une pression proche ou identique à celle qui règne à l'intérieur de la chambre réactionnelle 110.

Le chauffage assisté par plasma micro-ondes (PACVD), quant à lui, est produit à partir d'un ensemble classique comprenant un coupleur et une boîte d'accord 161, un guide métallique 162 recouvrant la chambre réactionnelle 110 sur toute sa longueur, un magnétron 160 et un générateur micro-ondes à puissance variable 163. De préférence, la puissance micro-ondes utilisée est supérieure à 500 Watts.

La figure 3 schématise de manière plus détaillée les sas d'entrée 131 et de sortie 132 situés aux deux extrémités de la chambre réactionnelle 110. Sur cette figure, la chambre réactionnelle 110 est schématisée de manière simplifiée par un carré, mais bien sûr en réalité elle se présente de la même manière que celle qui a été décrite au regard de la figure 2.

Les sas d'entrée 131 et de sortie 132 sont conçus de sorte qu'ils permettent le passage, à grande vitesse, de la fibre optique 2 de l'extérieur, où la pression est la pression atmosphérique, vers l'intérieur de la chambre réactionnelle 110 où la pression est de l'ordre du millibar (1mbar≅100Pa). La pression à l'intérieur des deux sas est donc identique ou proche de la pression régnant à l'intérieur de la chambre réactionnelle afin d'éviter des perturbations, dues à une chute brutale de la pression, susceptibles de se produire lors du dépôt. Pour cela, le pompage secondaire P2, ou différentiel, est effectué dans les deux sas 131 et 132.

Par ailleurs, pour supprimer toute entrée éventuelle d'oxygène, susceptible de ralentir le dépôt de bore et/ou de nitrure de bore et de détériorer la qualité de la couche de revêtement, le gaz vecteur argon est avantageusement introduit dans le sas d'entrée 131 entre le pompage différentiel P2 et la chambre réactionnelle 110.

Les gaz $H_2$-$BBr_3$ ou $NH_3$-$BBr_3$ sont introduits soit dans le sas d'entrée avec l'argon, soit directement dans la chambre réactionnelle, à son extrémité supérieure H, tel que représenté sur la figure 2.

Les sas d'entrée 131 et de sortie 132 comportent en outre des filières 135. Ces filières 135 permettent le passage de la fibre optique 2, défilant à grande vitesse, sans la fragiliser car elles permettent d'éviter tout contact.

Le sas d'entrée 131 comporte trois filières 135 séparées par deux espaces libres dans lesquels s'effectue respectivement le pompage différentiel P2 et l'introduction de l'argon. Le sas de sortie 132 comporte deux filières 135 séparées par un espace libre où s'effectue le pompage différentiel P2.

De préférence ces filières 135 se présentent sous une forme conique et, lorsque le diamètre de la fibre optique 2 est par exemple de 125 µm, leur diamètre varie linéairement de 300 à 700 µm. Elles sont réalisées dans un matériau de type céramique ou polymère tel que du polytétrafluoréthylène ou du polyamide -imide par exemple.

Les trois exemples décrits dans ce qui suit correspondent à trois séries d'essais différentes." Ils sont donnés à titre illustratif mais ne sont aucunement limitatifs.

Le dépôt de la couche de revêtement hermétique à base de bore et/ou de nitrure de bore, débute après l'étape de fibrage de la fibre 2, c'est-à-dire lorsque la fibre 2 présente un diamètre constant et qu'elle passe à l'intérieur de la chambre réactionnelle avec une vitesse de fibrage constante et en général supérieure à 20 m/min. Préalablement au dépôt un vide inférieur à $10^{-2}$ mbar ($\cong 1Pa$) est effectué dans la chambre réactionnelle.

Les différentes conditions opératoires lors du dépôt dépendent de plusieurs paramètres. Dans les exemples décrits ci-après, on a fait varier notamment les débits de gaz utilisés et la vitesse de fibrage.

Exemple 1 : (série d'essais n°1)

Cet exemple correspond à une première série d'essais dans laquelle les débits de gaz et la vitesse de fibrage varient dans une gamme de valeurs relativement faibles.

.  Longueur de la chambre réactionnelle:          800 mm
.  Température de $BBr_3$ :          40°C
.  Température du refroidisseur :          5°C
.  Température du substrat :          entre 500 et 850°C
.  Puissance micro-onde :          entre 500 et 1000 Watts
.  Vitesse de fibrage :          80 m/min.
.  Pression :          entre 0,2 et 0,8 mbar
.  Pression d'Ar dans le sas d'entrée :          entre 0,1 et 0,3 mbar
.  Débit d'Argon dans le bulleur de $BBr_3$ :          entre 10 et 20 $cm^3$/min
.  Débit d'hydrogène :          entre 200 et 400 $cm^3$/min

La couche de revêtement a été déposée sur une épaisseur comprise entre 100 et 500 Å ( 1 Angström = $10^{-10}$ mètres) selon les débits de gaz utilisés et la pression à l'intérieur de la chambre réactionnelle. Cette couche contient majoritairement du bore, de l'ordre de 80 à 95% et des quantités infimes (inférieures à 3%) de résidus tels que le brome. Cet exemple démontre qu'il est possible de réaliser un dépôt de revêtement hermétique avec des débits de gaz relativement faibles. L'argon permettant d'entraîner le mélange gazeux $H_2$-$BBr_3$, les quantités de réactifs utilisés sont moins importantes qu'en l'absence de ce gaz vecteur.

De plus, la présence de l'argon permet d'activer le plasma et donc d'augmenter la vitesse de décomposition de $BBr_3$. De ce fait, la vitesse de dépôt est augmentée et rendue compatible avec le procédé de fibrage. Cette vitesse de dépôt est, dans cet exemple, de l'ordre de 300 µm/h.

D'autre part, la paroi de la chambre réactionnelle étant refroidie à une température inférieure ou égale à 100°C, tout dépôt de bore ou de nitrure de bore sur cette paroi, entraînant une pollution de la chambre réactionnelle, est évité.

Il existe actuellement deux méthodes couramment utilisées pour caractériser une fibre optique d'un point de vue mécanique. L'une consiste à mesurer la résistance à la rupture et l'autre consiste à mesurer le facteur n qui rend compte de l'étanchéité et donc de la durée de vie de la fibre.

Dans cet exemple le facteur n mesuré est compris entre 80 et 95.

Exemple 2 (série d'essais n° 2).

Dans cet exemple, les conditions de débits, pression et vitesse de fibrage ont été augmentées par rapport à l'exemple 1.

.  Vitesse de fibrage:          200m/min
.  Pression:          entre 0,5 et 2 mbar
.  Pression d'Ar dans sas d'entrée:          entre 0,25 et 0,75 mbar
.  Débit d'Ar dans le bulleur de $BBr_3$ :          entre 50 et 100 $cm^3$/min
.  Débit d'hydrogène:          entre 500 et 1000 $cm^3$/min.

La couche de revêtement déposée présente une épaisseur comprise entre 300 et 1000 Å selon les conditions de débits et de pression choisies. La vitesse de dépôt est égale à 400 µm/min et le facteur n mesuré est supérieur à 100.

Exemple 3: (série d'essais n°3)

Cette série d'essais concerne un dépôt de bore et de nitrure de bore; l'ammoniac et l'hydrogène réagissant avec le tribromure de bore. La configuration du réacteur, la température du refroidisseur et du substrat sont identiques aux exemples précédents.

- . Vitesse de fibrage: 200m/min
- . Pression: entre 0,5 et 2 mbar
- . Pression d'Ar dans sas d'entrée: entre 0,25 et 0,75 mbar
- . Débit d'Ar dans le bulleur de BBr$_3$ : entre 50 et 100 cm$^3$/min
- . Débit d'ammoniac et d'hydrogène: entre 500 et 1000 cm$^3$/min.

L'épaisseur de la couche déposée varie d'une centaine d'angströms à environ 1000 Å selon les conditions de débits et de pression choisies. Le matériau déposé se compose majoritairement de bore et de nitrure de bore (environ 30 à 40%). La vitesse de dépôt est égale à 400 $\mu$m/h et le facteur n mesuré est égal à 100.

Les fibres réalisées au cours de ces trois séries d'essais présentent une résistance mécanique moyenne comparable à celle d'une fibre classique et un facteur n de l'ordre ou supérieur à 100. Les revêtements hermétiques sont déposés sur des épaisseurs comprises entre 100 et 1000 Å avec des vitesses comprises entre 300 et 500 $\mu$m/min. Par ailleurs, tout encrassement des parois de la chambre réactionnelle étant évité, le procédé selon l'invention permet de réaliser des dépôts sur de très grandes longueurs de fibres optiques, de l'ordre de 100 km ou même plus. Les propriétés initiales de la fibre sont également préservées puisqu'elle reste accordable et dénudable, avec des atténuations inférieures à 0,1 dB.

**Revendications**

1. Procédé de dépôt d'une couche de revêtement sur une fibre optique au cours de son fibrage, ladite couche de revêtement étant destinée à améliorer l'étanchéité et la durée de vie de ladite fibre optique, le procédé consistant à décomposer un mélange gazeux d'halogénure de bore et d'hydrogène et/ou d'halogénure de bore et d'ammoniac au moyen d'un apport d'énergie assisté par plasma micro-ondes, **caractérisé en ce que** l'opération de dépôt est réalisée sous une pression inférieure à 5 mbar, en présence d'un gaz vecteur pour d'une part entraîner ledit mélange gazeux vers un milieu réactionnel, et d'autre part activer le plasma.

2. Procédé selon la revendication 1, **caractérisé en ce que** l'halogénure de bore est du tribromure de bore.

3. Procédé selon l'une des revendications 1 à 2, **caractérisé en ce que** le gaz vecteur est de l'argon.

4. Procédé selon l'une des revendications 1 à 3, **caractérisé en ce que** le gaz vecteur s'écoule avec un débit compris entre 10 et 100 cm$^3$/min.

5. Procédé selon l'une des revendications 1 à 4, **caractérisé en ce que** l'on chauffe la fibre optique à une température comprise entre 400 et 850°C.

6. Procédé selon l'une des revendications 1 à 5, **caractérisé en ce que** l'on opère avec une vitesse de fibrage supérieure à 20 m/min.

7. Procédé selon l'une des revendications 1 à 6, **caractérisé en ce que** le débit d'hydrogène et/ou d'ammoniac est compris entre 200 et 1000 cm$^3$/min.

8. Procédé selon l'une des revendications 1 à 7, **caractérisé en ce que** le rapport volumique H$_2$/BBr$_3$ et/ou NH$_3$/BBr$_3$ est inférieur à 50 et de préférence compris entre 15 et 40.

9. Procédé selon l'une des revendications 1 à 8, **caractérisé en ce que** la puissance micro-ondes permettant de produire le plasma est comprise entre 500 et 1000 watts.

10. Dispositif de mise en oeuvre du procédé selon l'un quelconque des revendications 1 à 9, **caractérisé en ce qu'**il comprend:

- une chambre réactionnelle (110) tubulaire comprenant, à chacune de ses extrémités respectivement un sas d'entrée (131) et un sas de sortie (132) permettant le passage de la fibre (2) à l'intérieur de ladite chambre,
- un système de refroidissement (120) permettant de maintenir la paroi de la chambre réactionnelle (110) à une température constante inférieure ou égale à 100°C,
- un groupe de pompage (150) relié d'une part à la chambre réactionnelle (120) pour piéger les gaz résiduels et maintenir une pression constante, et d'autre part aux sas d'entrée (131) et de sortie (132) pour maintenir une pression proche ou identique à celle qui règne à l'intérieur de la chambre réactionnelle,
- une centrale de gaz (140) reliée au sas d'entrée (131) et/ou à la chambre réactionnelle (110),
- des moyens (160, 161, 162, 163) de production d'un chauffage assisté par plasma micro-ondes.

**11.** Dispositif selon la revendication 10, **caractérisé en ce que** la chambre réactionnelle (110) est constituée d'un tube en quartz.

**12.** Dispositif selon l'une des revendications 10 à 11, **caractérisé en ce que** la chambre réactionnelle (110) comporte en outre une double paroi (121) à l'intérieur de laquelle circule une huile diélectrique dont la température est constante de manière à maintenir la paroi de la chambre réactionnelle à une température inférieure ou égale à 100°C.

**13.** Dispositif selon l'une des revendications 10 à 12, **caractérisé en ce que** les sas d'entrée (131) et de sortie (132) comportent respectivement trois et deux filières (135).

**14.** Dispositif selon la revendication 13, **caractérisé en ce que** les filières (135) présentent une forme conique.

**15.** Dispositif selon l'une des revendications 13 à 14, **caractérisé en ce que** les filières sont en céramique ou en polymère de type polytétrafluoroéthylène ou polyamide -imide.

**16.** Dispositif selon l'une des revendications 13 à 15, **caractérisé en ce que**, lorsque le diamètre de la fibre optique est de l'ordre de 125 mm, le diamètre des filières varie linéairement de 300 à 700 mm.

**17.** Fibre optique, **caractérisée en ce qu'**elle est directement recouverte d'une couche de bore et **en ce que** la couche de bore a une épaisseur comprise entre 100 et 1000 Å.

**18.** Fibre optique recouverte d'une couche de revêtement destinée à améliorer son étanchéité et sa durée de vie, **caractérisée en ce que** la couche de revêtement comporte simultanément du bore et du nitrure de bore et présente une épaisseur comprise entre 100 et 1000 Å.

**Patentansprüche**

**1.** Verfahren zur Abscheidung einer Beschichtung auf einem Lichtwellenleiter im Laufe des Faserziehens, wobei die Beschichtung dazu vorgesehen ist, die Dichtigkeit und die Lebensdauer des Lichtwellenleiters zu verbessern, wobei das Verfahren darin besteht, ein Gasgemisch von Borhalogenid und Wasserstoff und/oder Borhalogenid und Ammoniak durch Mikrowellenplasma-gestützten Energieeintrag zu zersetzen, **dadurch gekennzeichnet, dass** die Abscheidung bei einem Druck unter 5 mbar in Gegenwart eines Trägergases durchgeführt wird, um einerseits das Gasgemisch in das Reaktionsmedium zu bringen und andererseits das Plasma zu aktivieren.

**2.** Verfahren nach Anspruch 1, **dadurch gekennzeichnet, dass** das Borhalogenid das Bortribomid ist.

**3.** Verfahren nach einem der Ansprüche 1 bis 2, **dadurch gekennzeichnet, dass** das Trägergas Argon ist.

**4.** Verfahren nach einem der Ansprüche 1 bis 3, **dadurch gekennzeichnet, dass** das Trägergas mit einem Durchsatz von 10 bis 100 cm$^3$/min strömt.

**5.** Verfahren nach einem der Ansprüche 1 bis 4, **dadurch gekennzeichnet, dass** der Lichtwellenleiter auf eine Temperatur von 400 bis 850° C erwärmt wird.

**6.** Verfahren nach einem der Ansprüche 1 bis 5, **dadurch gekennzeichnet, dass** bei einer Ziehgeschwindigkeit über 20 m/min gearbeitet wird.

**7.** Verfahren nach einem der Ansprüche 1 bis 6, **dadurch gekennzeichnet, dass** der Durchsatz von Wasserstoff und/oder Ammoniak im Bereich von 200 bis 1000 cm$^3$/min liegt.

**8.** Verfahren nach einem der Ansprüche 1 bis 7, **dadurch gekennzeichnet, dass** das Volumenverhältnis $H_2/BBr_3$ und/oder $NH_3/BBr_3$ unter 50 und vorzugsweise im Bereich von 15 bis 40 liegt.

**9.** Verfahren nach einem der Ansprüche 1 bis 8, **dadurch gekennzeichnet, dass** die Mikrowellenleistung, mit der das Plasma erzeugt werden kann, im Bereich von 500 bis 1000 W liegt.

**10.** Vorrichtung zur Durchführung des Verfahrens nach einem der Ansprüche 1 bis 9, **dadurch gekennzeichnet, dass** sie umfasst:

- eine röhrenförmige Reaktionskammer (110), die an den Enden eine Einlassschleuse (131) bzw. eine Auslassschleuse (132) aufweist, die es ermöglichen, dass der Lichtwellenleiter (2) kontinuierlich in die Kammer eingeführt werden kann,
- ein Kühlsystem (120), mit dem die Wand der Reaktionskammer (110) auf einer konstanten Temperatur von höchstens 100 °C gehalten werden kann,
- einen Pumpensatz (150), der einerseits mit der Reaktionskammer (120) verbunden ist, um das restliche Gas abzufangen und den Druck konstant zu halten, und andererseits mit der Einlassschleuse (131) und der Auslassschleuse (132) verbunden ist, um einen Druck aufrechtzuerhalten, der mit dem Druck im Inneren der Reaktionskammer identisch ist oder in der Nähe dieses Drucks liegt,

- eine zentrale Gaseinheit (140), die mit der Einlassschleuse (131) und/oder der Reaktionskammer (110) verbunden ist, und
- Einrichtungen (160, 161, 162, 163) zum Mikrowellenplasmagestützten Erwärmen.

**11.** Vorrichung nach Anspruch 10, **dadurch gekennzeichnet, dass** die Reaktionskammer (110) aus einem Quarzrohr besteht.

**12.** Vorrichtung nach einem der Ansprüche 10 bis 11, **dadurch gekennzeichnet, dass** die Reaktionskammer (110) ferner eine Doppelwand (121) aufweist, in deren Inneren ein dielektrisches Öl umläuft, dessen Temperatur konstant ist, um die Wand der Reaktionskammer auf einer Temperatur von 100° C oder darunter zu halten.

**13.** Vorrichtung nach einem der Ansprüche 10 bis 12, **dadurch gekennzeichnet, dass** die Einlassschleuse (131) und die Auslassschleuse (132) drei bzw. zwei Düsen (135) aufweist.

**14.** Vorrichtung nach Anspruch 13, **dadurch gekennzeichnet, dass** die Düsen (135) eine konische Form haben.

**15.** Vorrichtung nach einem der Ansprüche 13 bis 14, **dadurch gekennzeichnet, dass** die Düsen aus Keramik oder einem Polymer vom Typ Polytetrafluorethylen oder Polyamidimid bestehen.

**16.** Vorrichtung nach einem der Ansprüche 13 bis 15, **dadurch gekennzeichnet, dass** der Durchmesser der Düsen sich linear von 300 auf 700 mm ändert, wenn der Durchmesser des Lichtwellenleiters in der Größenordnung von 125 mm liegt.

**17.** Lichtwellenleiter, **dadurch gekennzeichnet, dass** er direkt mit einer Schicht aus Bor bedeckt ist und dadurch, dass die Borschicht eine Dicke im Bereich von 100 bis 1000 Å aufweist.

**18.** Lichtwellenleiter, der mit einer Beschichtung bedeckt ist, die dazu dient, seine Dichtigkeit und seine Lebensdauer zu verbessern, **dadurch gekennzeichnet, dass** die Beschichtung gleichzeitig Bor und Bornitrid aufweist und eine Dicke von 100 bis 1000 Å besitzt.

## Claims

**1.** Process for depositing a coating layer on an optical fibre while it is being drawn, the said coating layer being intended to improve the sealing and the lifetime of the said optical fibre, the process consisting in decomposing a boron halide-hydrogen and/or boron halide-ammonia gas mixture by means of microwave-plasma-enhanced energy injection, **characterized in that** the deposition operation is carried out under a pressure of less than 5 mbar, in the presence of a carrier gas for carrying the said gas mixture to the reaction medium on the one hand, and for activating the plasma on the other.

**2.** Process according to Claim 1, **characterized in that** the boron halide is boron tribromide.

**3.** Process according to either of Claims 1 and 2, **characterized in that** the carrier gas is argon.

**4.** Process according to one of Claims 1 to 3, **characterized in that** the carrier gas flows with a flow rate of between 10 and 100 $cm^3$/min.

**5.** Process according to one of Claims 1 to 4, **characterized in that** the optical fibre is heated to a temperature between 400 and 850°C.

**6.** Process according to one of Claims 1 to 5, **characterized in that** the drawing operation is carried out at a rate of greater than 20 m/min.

**7.** Process according to one of Claims 1 to 6, **characterized in that** the hydrogen and/or ammonia flow rate is between 200 and 1000 $cm^3$/min.

**8.** Process according to one of Claims 1 to 7, cahracterized in that the $H_2$/$BBr_3$ and/or $NH_3$/$BBr_3$ volume ratio is less than 50 and preferably between 15 and 40.

**9.** Process according to one of Claims 1 to 8, **characterized in that** the microwave power for producing the plasma is between 500 and 1000 watts.

**10.** Installation for implementing the process according to any one of Claims 1 to 9, **characterized in that** it comprises:

- a tubular reaction chamber (110) comprising, at each of its ends, respectively, an inlet lock (131) and an outlet lock (132) allowing the fibre (2) to pass through the said chamber;
- a cooling system (120) for keeping the wall of the reaction chamber (110) at a constant temperature of less than or equal to 100°C;
- a pumping set (150) connected, on the one hand, to the reaction chamber (120) in order to trap the residual gases and maintain a constant pressure and, on the other hand, to the inlet (131) and outlet (132) locks in order to maintain a pressure close or identical to that obtaining inside the reaction chamber;
- a gas control unit (140) connected to the inlet lock (131) and/or to the reaction chamber (110); and
- means (160, 161, 162, 163) for producing microwave-plasma-enhanced heating.

**11.** Installation according to Claim 10, **characterized in that** the reaction chamber (110) is formed by a quartz tube.

**12.** Installation according to either of Claims 10 and 11, **characterized in that** the reaction chamber (110) furthermore includes a double wall (121) inside which a dielectric oil circuits, the temperature of which is constant so as to maintain the wall of the reaction chamber at a temperature of less than or equal to 100°C.

**13.** Installation according to one of Claims 10 to 12, **characterized in that** the inlet (131) and outlet (132) locks comprise three and two orifices (135), respectively.

**14.** Installation according to Claim 13, **characterized in that** the orifices (135) are of conical shape.

**15.** Installation according to either of Claims 13 and 14, **characterized in that** the orifices are made of a ceramic or of a polymer of the polytetrafluoroethylene or polyamide imide type.

**16.** Installation according to one of Claims 13 to 15, cahracterized in that, when the diameter of the optical fibre is around 125 mm, the diameter of the orifices varies linearly from 300 to 700 mm.

**17.** Optical fibre, **characterized in that** it is directly coated with a boron layer and **in that** the boron layer has a thickness of between 100 and 1000 Å.

**18.** Optical fibre coated with a coating layer intended to improve its sealing and its lifetime, **characterized in that** the coating layer comprises simultaneously boron and boron nitride and has a thickness of between 100 and 1000 Å.

# FIG.1

FIG.2

## FIG.3